# EUROPEAN PATENT APPLICATION

(11) **EP 1 975 632 A1**
(43) Date of publication of application: **01.10.2008**
(21) Application number: 08152700.4
(22) Date of filing: 13.03.2008
(51) Int. Cl.: G01R 11/04, H02B 1/03, H05K 5/02

(54) **Electrical metering device**

(30) Priority: 29.03.2007 GB 0706186
(71) Applicant: Actaris UK Limited, Felixstowe, Suffolk IP11 2ER (GB)
(72) Inventor: Frost, Ian, Felixstowe, Suffolk IP11 0RN (GB); Barber, Andrew Peter, Dickleburgh, Norfolk IP24 4NR (GB)
(74) Representative: Hervouet, Sylvie

(57) **Abstract**

The invention relates to an electrical metering device (1) comprising a housing (2) with a back face (20), a front face (21) and lateral faces forming a closed box, and heat generating parts (5) internal to said housing (2) in close proximity to said back face, said electrical metering device (1) being adapted to be fixed to a vertical mounting backboard (4).
According to the invention, said electrical metering device (1) comprises a rear back cavity (6) extending behind said back face (20), and facing at least said heat generating parts (5), so as to create an air gap between said back face (20) and said vertical mounting backboard (4) when said electrical device is fixed to the vertical mounting backboard.

Advantages: improve thermal efficiency of metering devices with respect to external surfaces heating requirements.

## Description

The present invention relates to metering devices, and more especially to utility electrical metering devices which are installed in houses or buildings for counting the energy consumption of a user.

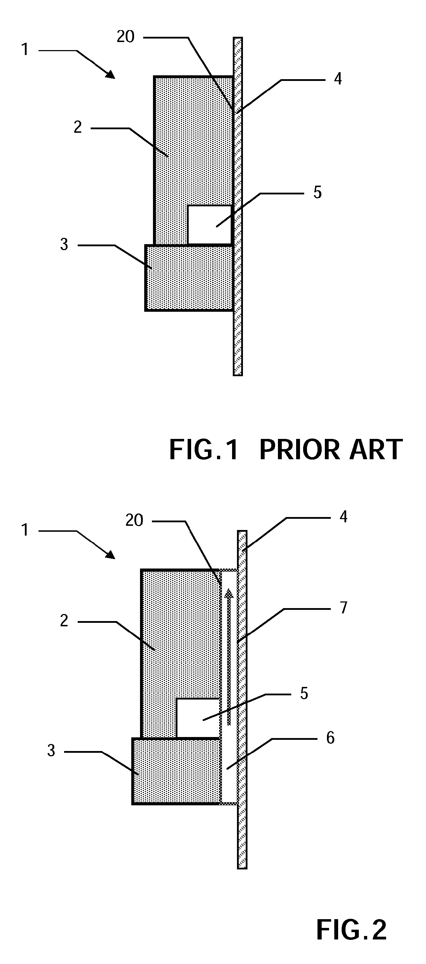

As shown on figure 1 which represents schematically a conventional installation of a metering device, a known metering device 1 comprises typically a housing 2 of substantial parallelepipedic shape and a terminal box 3, generally located at the bottom of housing 2. For use, metering device 1 is fixed generally vertically to a mounting backboard or wall 4. Conventional installation of metering device 1 places the external back face 20 of the housing in close proximity to mounting back board or wall 4. However, metering device 1 also comprises some internal parts, either inside housing 2 as shown, and/or in terminal box 3, which parts generate significant heat. These parts, which might comprise for instance electrical components such as those used for sensing the current or the voltage, are shown schematically in figure 1 under reference 5. These heat generating parts are generally in close proximity to the external back face 20 of metering device 1. Since housing 2 forms a closed box, the heat generated by these parts is thermally conducted through the external surfaces, and gets trapped between mounting backboard 4 and external back face 20, therefore causing external surface 20 to remain at higher temperatures than required. As a consequence, the meter device may fail to the approval tests that measure the external surfaces of the housing at various points. This is especially true for high current meter devices with contactors which generate significant heat.

An aim of the invention is to remedy the above drawback by proposing a solution which improves thermal efficiency and comply with heating regulations concerned by the external surfaces of a metering device.

To this aim, the invention proposes an electrical metering device comprising a housing with a back face, a front face and lateral faces forming a closed box, and heat generating parts internal to said housing in close proximity to said back face, said electrical metering device being adapted to be fixed to a vertical mounting backboard, characterized in that said electrical metering device comprises a rear back cavity extending behind said back face, and facing at least said heat generating parts, so as to create an air gap between said back face and said vertical mounting backboard when said electrical device is fixed to the vertical mounting backboard, said rear back cavity (6) being formed between said back face and a rear spacing plate used for fixing said electrical metering device to said vertical mounting backboard.

Thanks to the invention, the heat generation area of the meter is insulated from the back of the unit, where the temperature measurements are made to ensure compliance to the surface temperature requirements.

As shown on figure 2 which represents a first embodiment according to the invention, the rear back cavity 6 is formed through a rear spacing plate 7 extending parallel to back face 20 and integrally molded on housing 2. In this case, the meter device 1 can be directly fixed to mounting back board 4, thanks to any kind of fixation means (not shown).

Alternatively, rear back cavity is formed through an additional rear spacing fixing plate adapted to be assembled to the back face 20 of said device, parallel to said back face. This solution avoids the need to completely redesign the meter device. Only the additional fixing plate needs to be designed so as to fit with existing metering devices. Once the additional plate has been fixed to the rear of the existing metering device, the device can be fixed to mounting back board or wall 4.

In both cases, rear back cavity 6 spaces heat generating parts 5 of metering device 1 from mounting back board or wall 4. This in turn provides improved thermal efficiency by allowing the heat to circulate at least in the air gap. In a preferred embodiment, one or several apertures (not shown) may also be provided on the top and/or the bottom and/or lateral sides of the cavity so that heat can escape from the metering device, thus accelerating the cooling. Thanks to the invention, any metering devices, even high current metering devices, will benefit from improved performance against the heating requirements relating to external surfaces of the meter's housing.

## Claims

1. An electrical metering device (1) comprising a housing (2) with a back face (20), a front face (21) and lateral faces forming a closed box, and heat generating parts (5) internal to said housing (2) in close proximity to said back face, said electrical metering device (1) being adapted to be fixed to a vertical mounting backboard (4), **characterized in that** said electrical metering device (1) comprises a rear back cavity (6) extending behind said back face (20), and facing at least said heat generating parts (5), so as to create an air gap between said back face (20) and said vertical mounting backboard (4) when said electrical device is fixed to the vertical mounting backboard (4), said rear back cavity (6) being formed between said back face and a rear spacing plate used for fixing said electrical metering device to said vertical mounting backboard.

2. An electrical metering device (1) according to claim 1, **characterized in that** said rear spacing plate is adapted to be assembled to the back face (20) of said device, parallel to said back face (20).

3. An electrical metering device (1) according to claim 1, **characterized in that** said rear spacing plate (7) is integrally molded on said housing (2), extending parallel to said back face (20).

4. An electrical metering device (1) according to anyone of preceding claims, **characterized in that** at least one aperture is provided on at least one side of the rear back cavity to allow heat to escape from the metering device.
